# EUROPEAN PATENT APPLICATION

(11) **EP 4 478 863 A1**
(43) Date of publication of application: **18.12.2024**
(21) Application number: 23753174.4
(22) Date of filing: 09.02.2023
(51) Int. Cl.: H10K 50/84, H10K 59/38, H10K 59/122

(54) **LIGHT-EMITTING DISPLAY DEVICE AND COLOR CONVERSION PANEL**

(30) Priority: 09.02.2022 KR 20220017185; 03.11.2022 US 202217980514; 01.02.2023 CN 202310049738; 01.02.2023 CN 202320096659 U
(71) Applicant: Samsung Display Co., Ltd., Yongin-si, Gyeonggi-do 17113 (KR)
(72) Inventor: LEE, Seon Uk, Yongin-si Gyeonggi-do 17113 (KR); KIM, Min-Uk, Yongin-si Gyeonggi-do 17113 (KR); LEE, Songee, Yongin-si Gyeonggi-do 17113 (KR); HWANG, Sangyeon, Yongin-si Gyeonggi-do 17113 (KR)
(74) Representative: Dr. Weitzel & Partner
(86) International application number: PCT/KR2023/001904
(87) International publication number: WO 2023/153826

(57) **Abstract**

The present invention relates to a color conversion panel and a light emitting diode display including the same. The light emitting diode display includes: a first panel including an emission layer and a pixel definition layer having an opening for a light emitting diode (LED); and a second panel positioned on the first panel and including a bank and a plurality of spacing elements, wherein the bank overlap the plurality of spacing elements and includes a plurality of spacer support portions extending longitudinally in a first direction a greater than it extends in a second direction intersecting the first direction, and the plurality of spacing elements are disposed on the plurality of spacer support portions.

## Description

### [Technical Field]

Embodiments of the invention relate generally to a light emitting diode display, and more specifically, to a light emitting diode display including a color conversion panel having a spacer.

### [Background Art]

A light emitting diode display is a device that displays a screen, and includes a liquid crystal display (LCD), an organic light emitting diode (OLED) display, and the like. This light emitting diode display is used in various electronic devices such as portable phones, navigation devices, digital cameras, electronic books, portable game machines, or various terminals.

The organic light emitting diode (OLED) display includes two electrodes and an organic emission layer interposed therebetween. Electrons injected from one electrode and holes injected from the other electrode are recombined in the organic emission layer to generate excitons. The generated excitons are changed to a ground state from an exited state, releasing energy to emit light.

Recently, the light emitting diode display including a color conversion panel has been proposed to reduce light loss and provide a light emitting diode display having high color reproducibility. For example, the light emitting diode display may include a display panel and the color conversion panel overlapping the display panel. The color conversion panel may include a color conversion layer including semiconductor nanocrystals such as quantum dots, and may convert incident light into lights of different colors. Further, the color conversion panel may also include a spacer serving to maintain a gap between the two panels when the display panel and the color conversion panel are combined. For example, the spacer may be formed by patterning using a deposition mask.

The above information disclosed in this Background section is only for understanding of the background of the inventive concepts, and, therefore, it may contain information that does not constitute prior art.

### [Disclosure]

### [Technical Problem]

Applicant discovered that the patterned spacer may increase manufacturing cost and process time for the display device since the patterned spacer is formed by using a separate deposition mask process.

Light emitting diode displays including color conversion panels constructed according to the principle and illustrative embodiments of the invention are capable of reducing manufacturing cost and process time for display device by using a spacer formed by an inkjet method. In the inkjet method, ink is applied by a moving head to form the spacer at predetermined intervals. Applicant further discovered that the process tolerance in forming the spacers is very narrow, which could result in misalignment, quality and/or reliability issues.

In order to use the inkjet method to form the spacers, while avoiding the quality and reliability issues caused by narrow process tolerances, light emitting diode displays including color conversion panels constructed according to the principles and illustrative embodiments of the invention include spacers that may be formed along an area elongated in a direction generally orthogonal to the moving direction of the inkjet head to provide a margin area providing for greater tolerance or multiple positions for the spacer to be formed by any of the nozzles in the head of the inkjet apparatus. For example, the spacer may be formed on a bottom surface of a partition wall of the color conversion panel that is elongated in one direction to provide a margin area, thereby enabling the spacer may be formed thereon by an inkjet method, which also is used to form other components of the display device. Accordingly, the manufacturing cost and process time for the display device may be reduced.

Additional features of the inventive concepts will be set forth in the description which follows, and in part will be apparent from the description, or may be learned by practice of the inventive concepts.

### [Technical Solution]

According to one aspect of the invention, a light emitting diode display includes: a first panel including an emission layer and a pixel definition layer having an opening for a light emitting diode (LED); and a second panel positioned on the first panel and including a bank and a plurality of spacing elements, wherein the bank overlaps the plurality of spacing elements, and includes a plurality of spacer support portions extending longitudinally in a first direction a greater distance than it extends in a second direction intersecting the first direction, and the plurality of spacing elements are disposed on the plurality of spacer support portions.

A pitch of the plurality of spacing elements in the second direction may be substantially equal to an integer multiple of a pitch of a plurality of pixels in the second direction, and a pitch of the plurality of spacing elements in the first direction may not correspond to an integer multiple of a pitch of the plurality of pixels in the first direction.

The spacing elements are formed by a movable head of an inkjet apparatus, and the first direction may be substantially the same direction as an extending direction of the movable head and may be generally orthogonal to a direction in which the head of the inkjet apparatus moves.

The spacing elements may include spacers having a diameter of about 10 µm or more and about 30 µm or less, and a height of about 2 µm or more and about 10 µm or less.

The bank may include a partition wall and the spacer support portion may include a bottom portion of the partition wall, and a margin of the first direction of the spacer support portion excluding the spacer is about 14.1 µm or more and about 70.5 µm or less.

The head of the inkjet apparatus may include a plurality of nozzles, and the margin of the first direction may be substantially the same as a minimum interval of the plurality of nozzles in the first direction.

A length of the first direction of the bottom portion may be about 24.1 µm or more and about 90.5 µm or less.

The partition wall may further include an additional margin portion positioned around the bottom portion, and the additional margin portion may have a width of about 5 µm or more and about 15 µm or less.

A planar shape of the additional margin portion may be substantially the same as or different than a planar shape of the bottom portion.

The second panel may further include an upper capping layer, the upper capping layer may include one of a silicon nitride (SiNx), a silicon oxide (SiOx), and a silicon oxynitride (SiOxNy), and the upper capping layer may substantially entirely cover the bank and the spacing elements.

The second panel may further include an upper capping layer, the upper capping layer may include one of a silicon nitride (SiNx), a silicon oxide (SiOx), and a silicon oxynitride (SiOxNy), and the upper capping layer may be positioned between the bank and the spacing elements.

The bank may include a partition wall having a first opening, a second opening, and a third opening, and the second panel may further include a first color conversion layer positioned within the first opening, a second color conversion layer positioned within the second opening, and a transmission layer positioned within the third opening.

The opening for the light emitting diode may be provided as multiple to include a plurality of openings for the light emitting diode (LED), and the plurality of opening for the light emitting diode (LED) may overlap the first opening, the second opening, and the third opening of the partition wall, respectively.

The second panel may further include a first color filter, a second color filter, and a third color filter, the first color filter may overlap the first color conversion layer, the second color filter may overlap the second color conversion layer, the third color filter may overlap the transmission layer, and the second panel may further include a light blocking region where at least two color filters of the first color filter, the second color filter, and the third color filter overlap overlaps the partition wall.

The partition wall may further include a dummy opening, and the dummy opening may overlap the light blocking region.

According to another aspect of the invention, a color conversion panel includes: a plurality of spacing elements; a bank overlapping the plurality of spacing elements and including a plurality of spacer support portions extending elongate in a first direction, the bank further including a first opening, a second opening, and a third opening; a first color conversion layer positioned within the first opening; a second color conversion layer positioned within the second opening; and a transmission layer positioned within the third opening, wherein the plurality of spacing elements overlap a portion of the plurality of spacer support portions, respectively.

A plurality of spacing elements may include a plurality of spacers having a pitch in the first direction different from a pitch in a second direction generally perpendicular to the first direction.

The plurality of spacing elements may include a plurality of spacers formed by a movable head of an inkjet apparatus, and the first direction may be substantially the same direction as an extending direction of the movable head and may be generally orthogonal to a direction in which the head of the inkjet apparatus moves.

The bank may include a partition wall and the plurality of spacer support portions may include a plurality of bottom portions of the partition wall, and the partition wall further includes a plurality of additional margin portions positioned around a plurality of bottom portions respectively, each of the plurality of spacers may have a diameter of about 10 µm or more and about 30 µm or less, and a height of about 2 µm or more and about 10 µm or less, a margin of the first direction of the spacer support portion excluding the spacer positioned at each of the plurality of bottom portions may be about 14.1 µm or more and about 70.5 µm or less, and each of the plurality of additional margin portions may have a width of about 5 µm or more and about 15 µm or less.

A first color filter, a second color filter, and a third color filter may be further included, the first color filter may overlap the first color conversion layer, the second color filter may overlap the second color conversion layer, and the third color filter may overlap the transmission layer, a light blocking region where at least two color filters among the first color filter, the second color filter, and the third color filter overlap may overlap the bank, the bank may further include a dummy opening, and the dummy opening overlaps the light blocking region.

### [Advantageous Effects]

It is to be understood that both the foregoing general description and the following detailed description are exemplary and explanatory and are intended to provide further explanation of the invention as claimed.

### [Description of the Drawings]

FIG. 1 is a schematic cross-sectional view of an embodiment of a light emitting diode display constructed according to the principles of the invention.
FIG. 2 is a cross-sectional view of an embodiment of the color conversion panel shown in FIG. 1
FIG. 3 is a detailed cross-sectional view of the light emitting diode display of FIG. 1, including the color conversion panel of FIG. 2.
FIG. 4 is a cross-sectional view showing a step of forming a spacer in an inkjet method on the color conversion panel of FIG. 2.
FIG. 5 is a bottom plan view of an embodiment of the head of an inkjet apparatus of FIG. 4.
FIG. 6 is a top plan view of an embodiment of a spacer and a partition wall disposed around a spacer constructed according to the principles of the invention.
FIG. 7 is a top plan view showing various positions of the spacer of FIG.6.
FIG. 8 is a top plan view of an embodiment of a portion of the color conversion panel of FIG. 2.
FIG. 9 is a top plan view of a comparative example of a patterned spacer and a partition wall disposed around a spacer.
FIG. 10 is a top plan view of a comparative example of a color conversion panel.
FIG. 11 to FIG. 15 are top plan views of various embodiments of a spacer and a partition wall disposed around a spacer constructed according to the principles of the invention.
FIG. 16 and FIG. 17 are top plan views of other embodiments of a portion of the color conversion panel of FIG. 2.
FIG. 18 is a cross-sectional view of another embodiment of a color conversion panel constructed according to the principles of the invention.
FIG. 19 is a cross-sectional view of an embodiment of a light emitting diode display including the color conversion panel of FIG. 18.

### [Best mode for Invention]

The present invention relates to a color conversion panel and a light emitting diode display including the same. The light emitting diode display includes: a first panel including an emission layer and a pixel definition layer having an opening for a light emitting diode (LED); and a second panel positioned on the first panel and including a bank and a plurality of spacing elements, wherein the bank overlap the plurality of spacing elements and includes a plurality of spacer support portions extending longitudinally in a first direction a greater than it extends in a second direction intersecting the first direction, and the plurality of spacing elements are disposed on the plurality of spacer support portions

### [Mode for Invention]

The present invention will be described more fully hereinafter with reference to the accompanying drawings, in which embodiments of the invention are shown. As those skilled in the art would realize, the described embodiments may be modified in various different ways, all without departing from the spirit or scope of the present invention.

Descriptions of parts not related to the present invention are omitted, and like reference numerals designate like elements throughout the specification.

Further, since sizes and thicknesses of constituent members shown in the accompanying drawings are arbitrarily given for better understanding and ease of description, the present invention is not limited to the illustrated sizes and thicknesses. In the drawings, the thickness of layers, films, panels, regions, etc., are exaggerated for clarity. In the drawings, for better understanding and ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise", and variations such as "comprises" or "comprising", will be understood to imply the inclusion of stated elements but not the exclusion of any other elements.

Further, in the specification, the phrase "on a plane" means viewing the object portion from the top, and the phrase "on a cross-section" means viewing a cross-section of which the object portion is vertically cut from the side.

Throughout the specification, "connected" does not only mean that two or more constituent elements are directly connected, but when two or more constituent elements are connected indirectly through other constituent elements, and it may include a case where substantially integral parts are connected to each other even if they may be referred to by a different name depending on the position or function, as well as the case of being physically connected or electrically connected.

Also, throughout the specification, when it is said that parts such as wirings, layers, films, regions, plates, and constituent elements are "extended in the first direction or second direction", this does not mean only a straight-line shape extending straight in the corresponding direction, but it is a structure that extends overall along the first direction or the second direction, includes a structure that is bent and has a zigzag structure in a part, or includes extending while including a curved line structure.

In addition, electronic devices including display devices and display panels described in the specification (e.g., mobile phones, TV, monitors, laptop computers, etc.) or display devices and electronic devices including display panels, etc. manufactured by the manufacturing method described in the specification are not excluded from the right range of this specification.

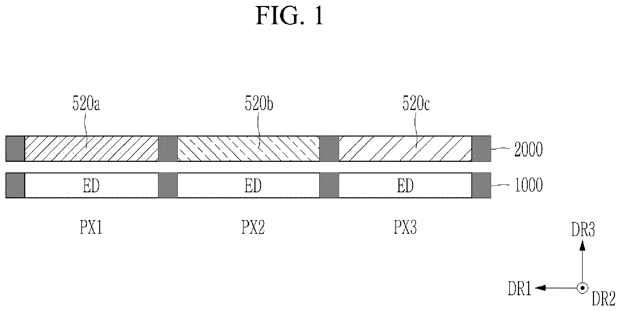

Hereinafter, a light emitting diode display according to an embodiment is described with reference to FIG. 1 to FIG. 3.

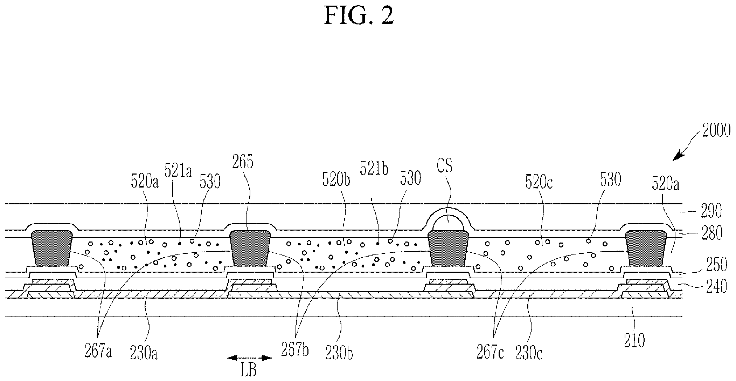

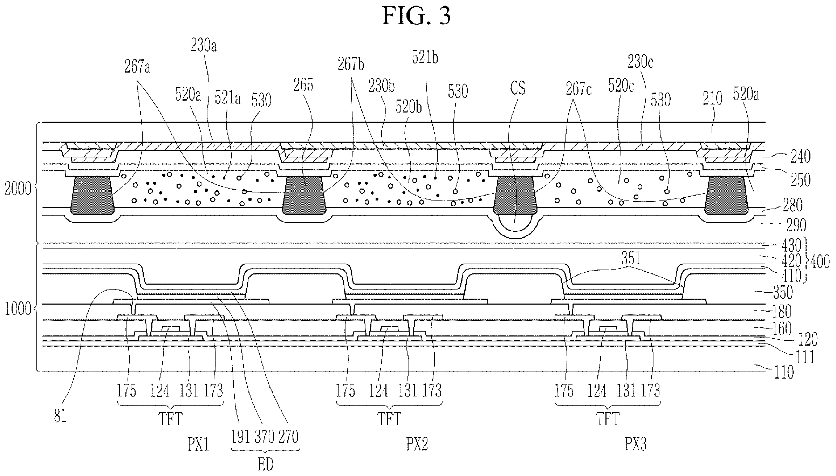

FIG. 1 is a schematic cross-sectional view of an embodiment of a light emitting diode display constructed according to the principles of the invention, FIG. 2 is a cross-sectional view of an embodiment of the color conversion panel shown in FIG. 1, and FIG. 3 is a detailed cross-sectional view of the light emitting diode display of FIG.1, including the color conversion panel of FIG. 2.

As shown in FIG. 1, a light emitting diode display according to an embodiment largely includes a display panel 1000 and a color conversion panel 2000 that overlap each other in the thickness direction DR3.

The display panel 1000 (hereinafter also referred to as a lower panel) may include a plurality of pixels PX1, PX2 and PX3, and a light-emitting element ED may be positioned for each of the pixels PX1, PX2, and PX3. That is, the display panel 1000 may include a plurality of light-emitting elements ED. A plurality of pixels PX1, PX2, and PX3 may include a first pixel PX1, a second pixel PX2, and a third pixel PX3. Each light-emitting element ED may emit light, and the display panel 1000 may display an image by expressing a luminance by controlling the intensity of light emitted from the light-emitting element ED of each pixel PX1, PX2, and PX3. Here, the color of the light emitted by the light-emitting element ED included in each of a plurality of pixels PX1, PX2, and PX3 may be substantially the same, and the color is converted into three primary colors in the color conversion panel 2000 to be described later, thereby displaying colors.

The light-emitting element ED may be composed of an organic light emitting element, and the display panel 1000 may be composed of an organic light emitting panel. However, the type of the display panel 1000 is not limited thereto, and various types of the panels may be used. For example, the display panel 1000 may be formed of a liquid crystal panel, an electrophoretic display panel, an electrowetting display panel, or the like. In addition, the display panel 1000 may be formed of a next-generation display panel such as a micro light emitting diode (LED) (Micro LED) display panel.

The display panel 1000 may be composed of a flat rigid display panel or a flexible display panel that may be flexibly bent.

The color conversion panel 2000 ( hereinafter also referred to as an upper panel) may be positioned to overlap and face the display panel 1000 in the thickness direction DR3. The color conversion panel 2000 may include a first color conversion layer 520a, a second color conversion layer 520b, and a transmission layer 520c. The first color conversion layer 520a may overlap the light-emitting element ED positioned at the first pixel PX1 in the thickness direction DR3. Light emitted from the light-emitting element ED of the first pixel PX1 may pass through the first color conversion layer 520a to emit light of a first wavelength. The second color conversion layer 520b may overlap the light-emitting element ED positioned at the second pixel PX2 in the thickness direction DR3. Light emitted from the light-emitting element ED of the second pixel PX2 may pass through the second color conversion layer 520b to emit light of a second wavelength. The transmission layer 520c may overlap the light-emitting element ED positioned at the third pixel PX3 in the thickness direction DR3. The light emitted from the light-emitting element ED of the third pixel PX3 passes through the transmission layer 520c and may emit light of a third wavelength as it is. For example, light of the first wavelength may be red light, light of the second wavelength may be green light, and light of the third wavelength may be blue light. That is, the first pixel PX1, the second pixel PX2, and the third pixel PX3 may be a red pixel, a green pixel, and a blue pixel, respectively. However, the embodiments are not limited thereto, and the colors displayed by the first pixel PX1, the second pixel PX2, and the third pixel PX3 may be variously changed. Also, in addition to the first pixel PX1, the second pixel PX2, and the third pixel PX3, a pixel displaying a different color may be additionally included.

Hereinafter, a layered structure of the color conversion panel 2000 of the light emitting diode display according to an embodiment is described in detail with reference to FIG. 2 and FIG. 3.

The color conversion panel 2000 may include a substrate 210 ( also referred to as an upper substrate), and a first color filter 230a, a second color filter 230b, and a third color filter 230c positioned on one side surface of the substrate 210.

The first color filter 230a may transmit the light of the first wavelength and absorb the light of the remaining wavelength, thereby increasing the purity of the light of the first wavelength emitted to the outside of the light emitting diode display.

The second color filter 230b may transmit the light of the second wavelength and absorb the light of the remaining wavelength, thereby increasing the purity of the light of the second wavelength emitted to the outside of the light emitting diode display.

The third color filter 230c may transmit the light of the third wavelength and absorb the light of the remaining wavelength, thereby increasing the purity of the light of the third wavelength emitted to the outside of the light emitting diode display.

The first color filter 230a, the second color filter 230b, and the third color filter 230c may be positioned to overlap the different pixels PX1, PX2, and PX3, respectively, in the thickness direction DR3. At each boundary of the pixels PX1, PX2, and PX3, the first color filter 230a, the second color filter 230b, and the third color filter 230c may overlap each other to form a light blocking region LB. In the light blocking region LB, the first color filter 230a, the second color filter 230b, and the third color filter 230c are all shown to overlap, but are not limited thereto. For example, two color filters among the first color filter 230a, the second color filter 230b, and the third color filter 230c may overlap to form the light blocking region. For example, at the boundary between the first pixel PX1 and the second pixel PX2, the first color filter 230a and the second color filter 230b may overlap. At the boundary between the second pixel PX2 and the third pixel PX3, the second color filter 230b and the third color filter 230c may overlap. At the boundary between the third pixel PX3 and the first pixel PX1, the third color filter 230c and the first color filter 230a may overlap.

A low refractive index layer 240 may be positioned on the first color filter 230a, the second color filter 230b, and the third color filter 230c. The low refractive index layer 240 may overlap all of the first color filter 230a, the second color filter 230b, and the third color filter 230c. That is, the low refractive index layer 240 may be entirely positioned on the substrate 210. The low refractive index layer 240 may include an organic material or an inorganic material having a low refractive index. For example, the refractive index of the low refractive index layer 240 may be greater than or equal to about 1.1 and less than or equal to about 1.3.

A first capping layer 250 (hereinafter also referred to as a lower capping layer) may be positioned on the low refractive index layer 240. The first capping layer 250 is a layer for protecting the low refractive index layer 240 and may include an inorganic insulating material such as a silicon nitride (SiNx), a silicon oxide (SiOx), or a silicon oxynitride (SiOxNy). The first capping layer 250 may be a single-layered or multi-layered structure of the material.

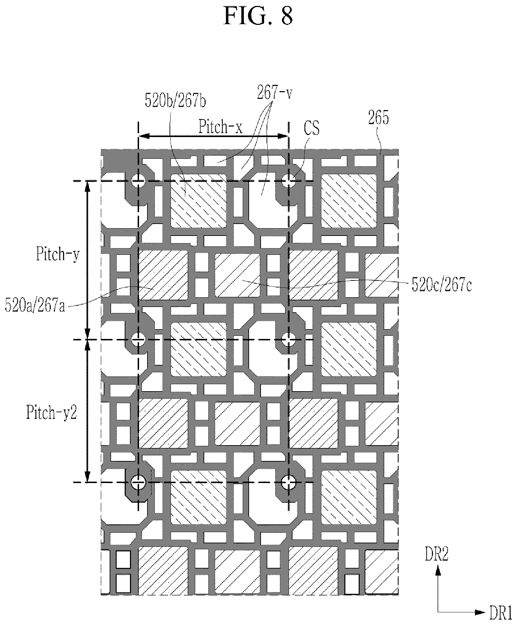

A bank, which may be in the form of a partition wall 265 may be positioned on the first capping layer 250. The partition wall 265 may include a first opening 267a vertically overlapping the first color filter 230a, a second opening 267b vertically overlapping the second color filter 230b, and a third opening 267c vertically overlapping the third color filter 230c. The first opening 267a may overlap the light emitting region of the first pixel PX1, the second opening 267b may overlap the light emitting region of the second pixel PX2, and the third opening 267c may overlap the light emitting region of the third pixel PX3. The partition wall 265 may overlap the light blocking region where the first color filter 230a, the second color filter 230b, and the third color filter 230c overlap each other. Accordingly, the partition wall 265 may overlap the boundary between the pixels PX1, PX2, and PX3. The partition wall 265 additionally includes a dummy opening that overlaps the light blocking region where the first color filter 230a, the second color filter 230b and the third color filter 230c overlap each other (referring to 267-v of FIG. 8).

The first color conversion layer 520a may be positioned within the first opening 267a, the second color conversion layer 520b may be positioned within the second opening 267b, and the transmission layer 520c may be positioned within the third opening 267c. On the other hand, the color conversion layer may not be positioned in the dummy opening, but when the color conversion layer is formed, the material of the color conversion layer may flow into some dummy openings and be positioned.

The first color conversion layer 520a may overlap the first color filter 230a. The first color conversion layer 520a may not overlap the second color filter 230b and the third color filter 230c. The first color conversion layer 520a may convert the light incident from the light-emitting element ED of the first pixel PX1 into light of the first wavelength. In this case, the light of the first wavelength may be red light having a maximum emission peak wavelength of about 600 nm to about 650 nm, for example, about 620 nm to about 650 nm. According to an embodiment, the first color conversion layer 520a may include a plurality of first quantum dots 521a and a plurality of scatterers 530.

The second color conversion layer 520b may overlap the second color filter 230b. The second color conversion layer 520b may not overlap the first color filter 230a and the third color filter 230c. The second color conversion layer 520b may convert the light incident from the light-emitting element ED of the second pixel PX2 into the light of the second wavelength. In this case, the light of the second wavelength may be green light having a maximum emission peak wavelength of about 500 nm to about 550 nm, for example, about 510 nm to about 550 nm. According to an embodiment, the second color conversion layer 520b may include a plurality of second quantum dots 521b and a plurality of scatterers 530.

The transmission layer 520c may overlap the third color filter 230c. The transmission layer 520c may not overlap the first color filter 230a and the second color filter 230b. The transmission layer 520c may transmit the light incident from the light-emitting element ED of the third pixel PX3. The light passing through the transmission layer 520c may be light of a third wavelength. The light of the third wavelength may be blue light having a maximum emission peak wavelength of about 380 nm to about 480nm, for example, about 420 nm or more, about 430 nm or more, about 440 nm or more, or about 445 nm or more, and about 470 nm or less, about 460 nm or less, or about 455 nm or less. According to the embodiment, the transmission layer 520c may include a plurality of scatterers 530, but may not include quantum dots.

A plurality of scatterers 530 may improve a light efficiency by scattering the light incident to the first color conversion layer 520a, the second color conversion layer 520b, and the transmission layer 520c. The scatterers 530 may include a material such as TiO2, SiO2, BaSO4, ZnO, Al2O3, CaCO3, etc. The particle size of the scatterers 530 may be greater than or equal to about 50 nm and less than or equal to about 800 nm.

The first quantum dot 521a and the second quantum dot 521b (hereinafter, the quantum dot is referred to as a semiconductor nanocrystal) may each independently include a Group II-VI compound, a Group III-V compound, a Group IV-VI compound, a Group IV element or compound, a Group I-III-VI compound, a Group II-III-VI compound, a Group I-II-IV-VI compound, or combinations thereof. The quantum dot such as the first quantum dot 521a and the second quantum dot 521b may not include cadmium.

The Group II-VI compound may be selected from a group including a binary compound selected from a group consisting of CdSe, CdTe, ZnS, ZnSe, ZnTe, ZnO, HgS, HgSe, HgTe, MgSe, MgS, and a mixture thereof; a ternary compound selected from a group consisting of AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from a group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof. The Group II-VI compound may further include a Group III metal.

The Group III-V compound may be selected from a group including a binary compound selected from a group consisting of GaN, GaP, GaAs, GaSb, AlN, AlP, AlAs, AlSb, InN, InP, InAs, InSb, and a mixture thereof; a ternary compound selected from a group consisting of GaNP, GaNAs, GaNSb, GaPAs, GaPSb, AlNP, AlNAs, AlNSb, AlPAs, AlPSb, InGaP, InNP, InNAs, InNSb, InPAs, InZnP, InPSb, and a mixture thereof; and a quaternary compound selected from a group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. The Group III-V compound may further include a Group II metal (e.g., InZnP).

The Group IV-VI compound may be selected from a group including a binary compound selected from a group consisting of SnS, SnSe, SnTe, PbS, PbSe, PbTe, and a mixture thereof; a ternary compound selected from a group consisting of SnSeS, SnSeTe, SnSTe, PbSeS, PbSeTe, PbSTe, SnPbS, SnPbSe, SnPbTe, and a mixture thereof; and a quaternary compound selected from a group consisting of SnPbSSe, SnPbSeTe, SnPbSTe, and a mixture thereof.

The Group IV element or compound may be selected from a group including a single element compound selected from a group consisting of Si, Ge, and combinations thereof; and a binary element compound selected from a group consisting of SiC, SiGe, and combinations thereof.

The Group I-III-VI compound may be selected from a group including CuInSe2, CuInS2, CuInGaSe, and CuInGaS, however it is not limited thereto.

The Group II-III-VI compound may be selected from a group consisting of ZnGaS, ZnAlS, ZnInS, ZnGaSe, ZnAlSe, ZnInSe, ZnGaTe, ZnAlTe, ZnInTe, ZnGaO, ZnAlO, ZnInO, HgGaS, HgAIS, HgInS, HgGaSe, HgAlSe, HgInSe, HgGaTe, HgAlTe, HgInTe, MgGaS, MgAIS, MgInS, MgGaSe, MgAlSe, MgInSe, and combinations thereof.

The Group I-II-IV-VI compound may be selected from CuZnSnSe and CuZnSnS, however it is not limited thereto.

In one embodiment, the quantum dots may not include cadmium. The quantum dots may include a semiconductor nanocrystal based on a Group III-V compound including indium and phosphorus. The Group III-V compound may further include zinc. The quantum dots may include a semiconductor nanocrystal based on a Group II-VI compound including a chalcogen element (e.g., sulfur, selenium, tellurium, or combinations thereof) and zinc.

In the quantum dots, the binary compound, the ternary compound, or the quaternary compound as above-described may be present in the particle at a substantially uniform concentration or at a concentration distribution that may be partially divided into different states. Also, they may have a core/shell structure in which one quantum dot surrounds another quantum dot. The interface between the core and the shell may have a concentration gradient in which the concentration of the elements present in the shell decreases toward the center.

In some embodiments, the quantum dots may have a core/shell structure including a core including the above-described nanocrystal and a shell surrounding the core. The shell of the quantum dot may act as a protective layer for maintaining the semiconductor characteristic by preventing a chemical modification of the core and/or a charging layer for imparting an electrophoretic characteristic to the quantum dot. The shell may be single-layered or multi-layered. The interface between the core and the shell may have a concentration gradient in which the concentration of elements present in the shell decreases toward the center. Examples of the shell of the quantum dot include a metal or non-metal oxide, a semiconductor compound, or a combination thereof.

For example, the metal or non-metal oxide may be exemplified as a binary compound such as SiO2, Al2O3, TiO2, ZnO, MnO, Mn2O3, Mn3O4, CuO, FeO, Fe2O3, Fe3O4, CoO, Co3O4, NiO, or a ternary compound such as MgAl2O4, CoFe2O4, NiFe2O4, and CoMn2O4, however the embodiments are not limited thereto.

Also, the semiconductor compound may be exemplified as CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and AlSb, however the illustrated embodiment it not limited thereto.

According to an embodiment, an interface between the core and the shell may have a concentration gradient, such that the concentration of an element existing in the shell is gradually reduced as it nears the center thereof. In addition, the semiconductor nanocrystals may have a structure including one semiconductor nanocrystal core and multi-layered shells surrounding the core. In an embodiment, the multi-layered shells may have two or more layers, for example, two, three, four, five, or more layers. Two adjacent layers of the shell may have a single composition or different compositions. In the multi-layered shell, each layer may have a composition that varies along the radius.

The quantum dots may have a full width at half maximum (FWHM) of about 45 nm or less, preferably about 40 nm or less, more preferably about 30 nm or less, and may improve color purity or color reproducibility in this range. Also, since light emitted through the quantum dots is emitted in all directions, a wide viewing angle may be improved.

In the quantum dots, the shell material and the core material may have different energy bandgaps from each other. For example, the energy bandgap of the shell material may be greater than that of the core material. Alternatively, the energy bandgap of the shell material may be smaller than that of the core material. The quantum dots may have a multi-layered shell. In the multi-layered shell, the energy bandgap of the outer layer may be greater than the energy bandgap of the inner layer (i.e., the layer nearer to the core). In the multi-layered shell, the energy bandgap of the outer layer may be less than the energy bandgap of the inner layer.

The quantum dots may control an absorption/emission wavelength by adjusting a composition and a size thereof. A maximum peak emission wavelength of the quantum dot may be an ultraviolet (UV) to infrared wavelength, or a wavelength of greater than the above wavelength range.

The quantum dots may include an organic ligand (e.g., having a hydrophobic moiety). The organic ligand may be bound to surfaces of the quantum dots. The organic ligand may include RCOOH, RNH2, R2NH, R3N, RSH, R3PO, R3P, ROH, RCOOR, RPO (OH)2, RHPOOH, R2POOH, or combinations thereof, and herein, R is independently a substituted or unsubstituted C3 to C40 aliphatic hydrocarbon group such as a substituted or unsubstituted C3 to C40 (e.g., C5 or greater and C24 or smaller) alkyl, or a substituted or unsubstituted C3 to C40 alkenyl, a substituted or unsubstituted C6 to C40 (e.g., C6 or greater and C20 or smaller)aromatic hydrocarbon group such as a substituted or unsubstituted C6 to C40 aryl group, or a combination thereof.

Examples of the organic ligand may be a thiol compound such as methane thiol, ethane thiol, propane thiol, butane thiol, pentane thiol, hexane thiol, octane thiol, dodecane thiol, hexadecane thiol, octadecane thiol, or benzyl thiol; an amine such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, or trioctylamine; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, or benzoic acid; a phosphine compound such as methyl phosphine, ethyl phosphine, propyl phosphine, butyl phosphine, pentyl phosphine, octylphosphine, dioctyl phosphine, tributylphosphine, or trioctylphosphine; a phosphine compound or an oxide compound thereof such as methyl phosphine oxide, ethyl phosphine oxide, propyl phosphine oxide, butyl phosphine oxide pentyl phosphine oxide, tributylphosphine oxide, octylphosphine oxide, dioctyl phosphine oxide, or trioctylphosphine oxide; a diphenyl phosphine, a triphenyl phosphine compound, or an oxide compound thereof; a C5 to C20 alkyl phosphonic acid such as hexylphosphinic acid, octylphosphinic acid, dodecanephosphinic acid, tetradecanephosphinic acid, hexadecanephosphinic acid, or octadecanephosphinic acid; and the like, but are not limited thereto. The quantum dots may include a hydrophobic organic ligand alone or as a mixture of at least two types thereof. The hydrophobic organic ligand may not include a photopolymerizable moiety (e.g., an acrylate group, a methacrylate group, etc.).

Each of the first color conversion layer 520a, the second color conversion layer 520b, and the transmission layer 520c may further include a monomer. In this case, the monomer may be formed of a non-volatile monomer, and may be formed of an organic material for photocuring. The monomer may have an acrylate functional group at one end or both ends. The monomer may have a boiling point of about 200 °C or more and a characteristic of a vapor pressure of about 10-2 mmHg or less.

Each of the first color conversion layer 520a, the second color conversion layer 520b, and the transmission layer 520c may include two or more different monomers. That is, each of the first color conversion layer 520a, the second color conversion layer 520b, and the transmission layer 520c may include a first monomer and a second monomer. In this case, the first monomer and the second monomer may include different materials. In this case, the first monomer and the second monomer may have an acrylate functional group at one or both ends, respectively.

A spacing element, which may be in the form of spacer CS, is positioned on the partition wall 265. The spacer CS serves to maintain the gap between two panels when the display panel 1000 and the color conversion panel 2000 are combined. In the illustrated embodiment, the spacer CS is not patterned to be formed by using a mask, but the spacer CS is formed by an inkjet method.

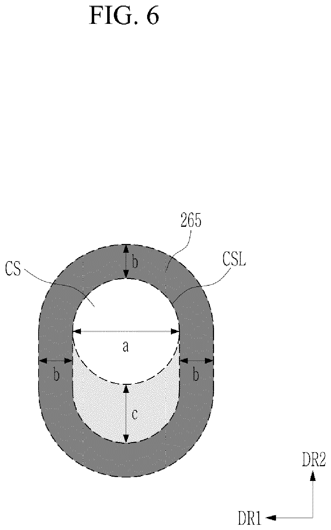

When the spacer CS is formed by the inkjet method, the position at which the spacer CS is formed may not be uniform compared to the case of being patterned using a deposition mask, but since the mask is not used, manufacturing costs and process time are reduced. Therefore, in the illustrated embodiment, in order to precisely form the spacer CS in the inkjet method without misalignment, a spacer support portion (referring to a spacer support portion CSL of FIG. 6), which may be a bottom surface of the partition wall 265, is formed elongate in the direction DR2 generally orthogonal to the direction that the inkjet head moves DR1 to facilitate forming the spacer CS at any one of multiple positions on the bottom surface of the partition walls 265. This is described in more detail with reference to FIG. 6.

A second capping layer 280 (hereinafter; referred to as an upper capping layer) may be positioned on the first color conversion layer 520a, the second color conversion layer 520b, the transmission layer 520c, the partition wall 265, and the spacer CS. The second capping layer 280 is substantially entirely positioned on the substrate 210, and may have a structure covering the first color conversion layer 520a, the second color conversion layer 520b, the transmission layer 520c, the partition wall 265, and the spacer CS. The second capping layer 280 is a layer covering and protecting the first color conversion layer 520a, the second color conversion layer 520b, and the transmission layer 520c, and may be formed of an inorganic material. For example, the second capping layer 280 may include an inorganic insulating material such as a silicon nitride (SiNx), a silicon oxide (SiOx), or a silicon oxynitride (SiOxNy). The second capping layer 280 may be a single-layered or multi-layered structure of the material. In the embodiment of FIG. 2, the second capping layer 280 is formed after the first color conversion layer 520a, the second color conversion layer 520b, the transmission layer 520c, and the spacer CS are formed. This embodiment may have a stacking process sequence in which the first color conversion layer 520a, the second color conversion layer 520b, and the transmission layer 520c are formed in the inkjet method between the partition walls 265, and then the spacer CS on the partition wall 265 is also formed in the inkjet method, and then the second capping layer 280 is stacked. As a result, the inkjet process may be applied continuously, so it may have the advantage of shortening the entire process time.

A filling layer 290 may be positioned on the second capping layer 280. The filling layer 290 may be positioned entirely over the substrate 210. The filling layer 290 is positioned between the display panel 1000 and the color conversion panel 2000 in the state where the display panel 1000 and the color conversion panel 2000 are bonded.

Hereinafter, the state that the display panel 1000 and the color conversion panel 2000 are combined is described with reference to FIG. 3. In FIG. 3, the color conversion panel 2000 shown in FIG. 2 may be combined to face the display panel 1000 with the top and bottom overturned state. Referring to FIG. 3, due to the spacer CS disposed on the color conversion panel 2000, the gap between the display panel 1000 and the color conversion panel 2000 may be maintained substantially constant when two panels are combined.

The display panel 1000 may include a substrate 110 (also referred to as a lower substrate), a transistor TFT including a semiconductor 131, a gate electrode 124, a source electrode 173 and a drain electrode 175, a gate insulating layer 120, a first interlayer insulating layer 160, an organic layer 180, a pixel electrode 191, an emission layer 370, a pixel definition layer 350, a common electrode 270, and an encapsulation layer 400, which are positioned on the substrate 110. According to the embodiment, the transistor TFT may not include the source electrode 173 or the drain electrode 175.

The substrate 110 may include a material having a rigid characteristic, such as glass, or a flexible material that may be bent, such as plastic or polyimide. On the substrate 110, a buffer layer 111 to flatten the surface of the substrate 110 and block impurity from penetrating into the semiconductor 131 may be further positioned. The buffer layer 111 may include an inorganic material, for example, an inorganic insulating material such as a silicon nitride (SiNx), a silicon oxide (SiOx), or a silicon oxynitride (SiOxNy). The buffer layer 111 may be a single-layered or multi-layered structure of the material. A barrier layer may be further positioned on the substrate 110. In this case, the barrier layer may be positioned between the substrate 110 and the buffer layer 111. The barrier layer may include an inorganic insulating material such as a silicon nitride (SiNx), a silicon oxide (SiOx), or a silicon oxynitride (SiOxNy). The barrier layer may be a single-layered or multi-layered structure of the material.

The semiconductor 131 may be positioned on the substrate 110. The semiconductor 131 may include any one of amorphous silicon, polycrystalline silicon, and an oxide semiconductor. For example, the semiconductor 131 may include a low temperature polysilicon (LTPS) or an oxide semiconductor material including at least one of zinc (Zn), indium (In), gallium (Ga), tin (Sn), and mixture thereof. For example, the semiconductor 131 may include Indium-Gallium-Zinc Oxide (IGZO). The semiconductor 131 may include a channel region, a source region, and a drain region that are classified according to whether or not impurity doping is performed. The source region and drain region may have conduction characteristics corresponding to conductors.

The gate insulating layer 120 may cover the semiconductor 131 and the substrate 110. The gate insulating layer 120 may include an inorganic insulating material such as a silicon nitride (SiNx), a silicon oxide (SiOx), or a silicon oxynitride (SiOxNy). The gate insulating layer 120 may have a single-layered or multi-layered structure of the material.

The gate electrode 124 may be positioned on the gate insulating layer 120. The gate electrode 124 may include a metal such as copper (Cu), molybdenum (Mo), aluminum (Al), silver (Ag), chromium (Cr), tantalum (Ta), or titanium (Ti) or a metal alloy. The gate electrode 124 may be formed as a single layer or multiple layers. The region overlapping the gate electrode 124 among the semiconductor 131 may be the channel region.

The first interlayer insulating layer 160 may cover the gate electrode 124 and the gate insulating layer 120. The first interlayer insulating layer 160 may include an inorganic insulating material such as a silicon nitride (SiNx), a silicon oxide (SiOx), or a silicon oxynitride (SiOxNy). The first interlayer insulating layer 160 may have a single-layered or multi-layered structure of the material.

The source electrode 173 and the drain electrode 175 may be positioned on the first interlayer insulating layer 160. The source electrode 173 and the drain electrode 175 are connected to the source region and the drain region of the semiconductor 131 through openings formed in the first interlayer insulating layer 160 and the gate insulating layer 120, respectively. The aforementioned semiconductor 131, gate electrode 124, source electrode 173, and drain electrode 175 constitute one transistor TFT. According to an embodiment, the transistor TFT may include only the source region and the drain region of the semiconductor 131 instead of the source electrode 173 and the drain electrode 175. Although one transistor TFT is illustrated in each of the pixels PX1, PX2, and PX3, the embodiments are not limited thereto, and a plurality of transistors TFTs may be positioned in each of the pixels PX1, PX2, and PX3.

The source electrode 173 and the drain electrode 175 may include a metal such as aluminum (Al), copper (Cu), silver (Ag), gold (Au), platinum (Pt), palladium (Pd), nickel (Ni), molybdenum (Mo), tungsten (W), titanium (Ti), chromium (Cr), and tantalum (Ta) or a metal alloy, or may include various transparent conductive oxide layers such as indium tin oxide (ITO). The source electrode 173 and the drain electrode 175 may be configured of a single layer or multiple layers. The source electrode 173 and the drain electrode 175 according to an embodiment may be configured of a triple layer including an upper layer, an intermediate layer, and a lower layer, the lower layer may include titanium (Ti), and the intermediate layer may include copper (Cu), and the upper layer may include indium tin oxide (ITO), which is a transparent conductive oxide layer.

The organic layer 180 may be positioned on the source electrode 173 and the drain electrode 175. The organic layer 180 covers the source electrode 173, the drain electrode 175, and the first interlayer insulating layer 160. The organic layer 180 is to planarize the surface of the substrate 110 on which the transistor TFT is formed, may be an organic insulator, and may include at least one material selected from a group consisting of polyimide, polyamide, acryl resin, benzocyclobutene, and phenol resin.

The pixel electrode 191 may be positioned on the organic layer 180. The pixel electrode 191 is also referred to as an anode, and may be configured of a single layer including a transparent conductive oxide layer or a metal material, or a multi-layer including these. The transparent conductive oxide layer may include indium tin oxide (ITO), poly-ITO, indium zinc oxide (IZO), indium gallium zinc oxide (IGZO), indium tin zinc oxide (ITZO), etc. The metal material may include silver (Ag), molybdenum (Mo), copper (Cu), gold (Au), and aluminum (Al).

The organic layer 180 may include a via hole 81 exposing the drain electrode 175. The drain electrode 175 and the pixel electrode 191 may be physically and electrically connected through the via hole 81 of the organic layer 180. Accordingly, the pixel electrode 191 may receive an output current to be transferred from the drain electrode 175 to the emission layer 370.

A pixel definition layer 350 may be positioned on the pixel electrode 191 and the organic layer 180. The pixel definition layer 350 includes a pixel opening 351 (hereinafter also referred to as an opening for a light emitting diode (LED)) overlapping at least a portion of the pixel electrode 191. In this case, the pixel opening 351 may overlap the central portion of the pixel electrode 191 and may not overlap the edge portion of the pixel electrode 191. Accordingly, the size of the pixel opening 351 may be smaller than the size of the pixel electrode 191. The pixel definition layer 350 may partition the formation position of the emission layer 370 so that the emission layer 370 may be positioned on the portion where the upper surface of the pixel electrode 191 is exposed. The pixel definition layer 350 may be an organic insulator including at least one material selected from the group consisting of polyimide, polyamide, acryl resin, benzocyclobutene, and phenol resin. According to an embodiment, the pixel definition layer 350 may be formed of a black pixel definition layer (BPDL) including a black color pigment.

The pixel definition layer 350 may be positioned at a boundary between a plurality of pixels PX1, PX2, and PX3. The pixel definition layer 350 may overlap the partition wall 265 of the color conversion panel 2000 vertically, and the pixel opening 351 of the pixel definition layer 350 may overlap also the first opening 267a, the second opening 267b, and the third opening 267c of the partition wall 265 vertically. Also, the pixel opening 351 of the pixel definition layer 350 may overlap the first color filter 230a, the second color filter 230b, and the third color filter 230c and may also overlap the first color conversion layer 520a, the second color conversion layer 520b, and the transmission layer 520c vertically. Also, the pixel definition layer 350 may overlap the light blocking region LB where the first color filter 230a, the second color filter 230b, and the third color filter 230c overlap.

A plurality of pixel openings 351 may each have a planar shape similar to that of the pixel electrode 191. For example, the pixel opening 351 and the pixel electrode 191 may consist of polygons. In this case, the corner portions of the pixel opening 351 and the pixel electrode 191 may be chamfered. However, the shape of the pixel opening 351 and the shape of the pixel electrode 191 are not limited thereto, and may be variously changed.

In this case, a plurality of pixel electrodes 191 corresponding to the first pixel PX1, the second pixel PX2, and the third pixel PX3 may have different sizes. Similarly, a plurality of pixel openings 351 corresponding to the first pixel PX1, the second pixel PX2, and the third pixel PX3 may have different sizes. For example, the pixel opening 351 and the pixel electrode 191 corresponding to the first pixel PX1 may have a larger size than the pixel opening 351 and the pixel electrode 191 corresponding to the second pixel PX2, respectively. Also, the pixel opening 351 and the pixel electrode 191 corresponding to the first pixel PX1 may have sizes smaller or similar to those of the pixel opening 351 and the pixel electrode 191 corresponding to the third pixel PX3, respectively. However, the embodiments are not limited thereto, and each of the pixel opening 351 and the pixel electrode 191 may be set to have various sizes.

The emission layer 370 may be positioned within the pixel opening 351 defined by the pixel definition layer 350. However, the embodiments are not limited thereto, and the emission layer 370 may be positioned on the pixel definition layer 350 as well as within the pixel opening 351. The emission layer 370 may be formed by performing a deposition process using an open mask in which a portion corresponding to the display area is opened. The emission layer 370 may include a low molecular weight or a high molecular weight organic material. Although the emission layer 370 is illustrated as a single layer, in reality, auxiliary layers such as an electron injection layer, an electron transport layer, a hole transport layer, and a hole injection layer may also be included above and below the emission layer 370. The hole injection layer and the hole transport layer may be positioned under the emission layer 370, and the electron transport layer and the electron injection layer may be positioned on the emission layer 370. According to an embodiment, the hole injection layer, the hole transport layer, the electron transport layer, and the electron injection layer may be positioned on the pixel definition layer 350 and may be positioned over the entire region of the substrate 110. In addition, another emission layer may be further positioned on the emission layer 370. That is, two or more emission layers 370 may be stacked.

A lower spacer may be further positioned on the pixel definition layer 350. The lower spacer may be formed from the same material as the pixel definition layer 350. However, the embodiments are not limited thereto, and the lower spacer may be made of a different material from that of the pixel definition layer 350. The lower spacer may be an organic insulator including at least one material selected from the group consisting of polyimide, polyamide, acryl resin, benzocyclobutene, and phenol resin.

The common electrode 270 may be positioned over the pixel definition layer 350 and the emission layer 370. The common electrode 270 of each pixel PX1, PX2, and PX3 may be connected to each other. The common electrode 270 may be formed to be entirely connected on the substrate 110. The common electrode 270 is also referred to as a cathode and may be formed of a transparent conductive layer including Indium Tin Oxide (ITO), Indium Zinc Oxide (IZO), Indium Gallium Zinc Oxide (IGZO), and Indium Tin Zinc Oxide (ITZO). The common electrode 270 may be made of a metal material such as silver (Ag) or magnesium (Mg), or a mixture thereof. At this time, the thickness of the common electrode 270 may be adjusted to be formed of a transparent conductive layer. In addition, the common electrode 270 may have a semi-transparent characteristic, and in this case, a micro-cavity may be formed together with the pixel electrode 191.

The pixel electrode 191, the emission layer 370, and the common electrode 270 may constitute the light-emitting element ED. In each of the pixels PX1, PX2, and PX3, a portion where the pixel electrode 191, the emission layer 370, and the common electrode 270 overlap may be a light emitting region of each light-emitting element ED.

The light-emitting element ED positioned at the first pixel PX1 may overlap the first color conversion layer 520a and the first color filter 230a vertically. The light-emitting element ED positioned at the first pixel PX1 may not vertically overlap the second color conversion layer 520b, the transmission layer 520c, the second color filter 230b, and the third color filter 230c. Light emitted from the light-emitting element ED of the first pixel PX1 may be converted into light of the first wavelength while passing through the first color conversion layer 520a, and may be emitted outside through the first color filter 230a.

The light-emitting element ED positioned at the second pixel PX2 may vertically overlap the second color conversion layer 520b and the second color filter 230b. The light-emitting element ED positioned at the second pixel PX2 may not vertically overlap the first color conversion layer 520a, the transmission layer 520c, the first color filter 230a, and the third color filter 230c. Light emitted from the light-emitting element ED of the second pixel PX2 may be converted into light of the second wavelength while passing through the second color conversion layer 520b, and may be emitted through the second color filter 230b to the outside.

The light-emitting element ED positioned at the third pixel PX3 may vertically overlap the transmission layer 520c and third color filter 230c. The light-emitting element ED positioned at the third pixel PX3 may not vertically overlap the first color conversion layer 520a, the second color conversion layer 520b, the first color filter 230a, and the second color filter 230b. The third wavelength light emitted from the light-emitting element ED of the third pixel PX3 may pass sequentially through the transmission layer 520c and the third color filter 230c to be emitted to the outside.

The encapsulation layer 400 may be positioned over the common electrode 270. The encapsulation layer 400 may include at least one inorganic layer and at least one organic layer. In the illustrated embodiment, the encapsulation layer 400 may include a first inorganic encapsulation layer 410, an organic encapsulation layer 420, and a second inorganic encapsulation layer 430. However, this is only an example, and the number of inorganic and organic layers constituting the encapsulation layer 400 may be variously changed. For example, the encapsulation layer 400 may be stacked in the order of the first inorganic encapsulation layer, the second inorganic encapsulation layer, the first organic encapsulation layer, and the third inorganic encapsulation layer. Alternatively, the encapsulation layer 400 may be stacked in the order of the first inorganic encapsulation layer, the first organic encapsulation layer, the second inorganic encapsulation layer, and the third inorganic encapsulation layer. The display panel 1000 may include a display area displaying a screen and a peripheral area surrounding the display area. The first inorganic encapsulation layer 410, the organic encapsulation layer 420, and the second inorganic encapsulation layer 430 may be positioned in a portion of the display area and the peripheral area. According to an embodiment, the organic encapsulation layer 420 may be formed around the display area, and the first inorganic encapsulation layer 410 and the second inorganic encapsulation layer 430 may be formed even in the peripheral area. The function of the encapsulation layer 400 is to protect the light-emitting element ED from moisture or oxygen that may penetrate from the outside, and the ends of one side of the first inorganic encapsulation layer 410 and the second inorganic encapsulation layer 430 may be formed to be in direct contact.

The encapsulation layer 400 may in contact with the color conversion panel 2000, and specifically, the encapsulation layer 400 may be in contact with the filling layer 290. Therefore, the second inorganic encapsulation layer 430 of the encapsulation layer 400 may be in contact with the filling layer 290. However, this is only an example, and another layer may be further positioned between the encapsulation layer 400 and the filling layer 290.

The light emitting diode display according to an embodiment may further include a sensing unit for sensing a touch. The sensing unit may include a plurality of sensing electrodes, and the sensing unit may be positioned between the display panel 1000 and the color conversion panel 2000.

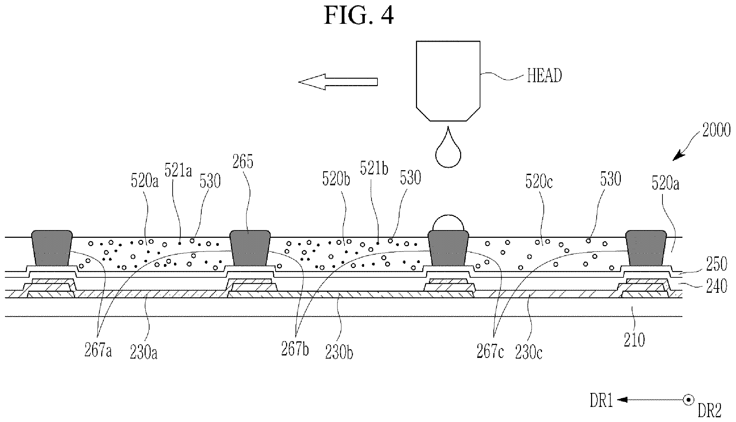

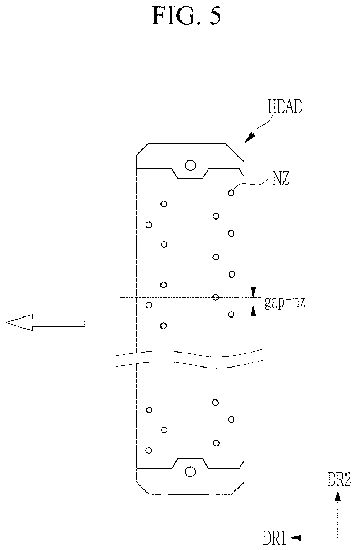

Hereinafter, the method of forming the spacer CS on the color conversion panel 2000 and the shape of the inkjet apparatus head are described with reference to FIG. 4 and FIG. 5.

FIG. 4 is a cross-sectional view showing a step of forming a spacer in an inkjet method on the color conversion panel of FIG. 2, and FIG. 5 is a bottom plan view of an embodiment of a head of an inkjet apparatus of FIG. 4.

In FIG. 4, a color conversion panel 2000 according to the step of forming a first color conversion layer 520a, a second color conversion layer 520b, and a transmission layer 520c in a first opening 267a, a second opening 267b, and a third opening 267c respectively, is shown after forming a partition wall 265 including a first opening 267a, a second opening 267b, and a third opening 267c on a substrate 210. After that, the step of forming the spacer CS in the inkjet method is shown in FIG. 4.

As shown in FIG. 4, the head HEAD of the inkjet apparatus moves in the arrow direction (hereinafter, also referred to as a movement direction DR1) while emitting ink to form the spacer CS. At this time, referring to FIG.5, the head HEAD of the inkjet apparatus has a structure that is elongated in a direction DR2 (hereinafter, also referred to as head extension direction DR2 or extending direction DR2) generally orthogonal to the movement direction DR1.

In FIG. 5, the head HEAD of the inkjet apparatus is viewed from the substrate side, and a plurality of nozzles NZ are arranged. Referring to FIG. 5, the adjacent nozzles NZ may be arranged with an interval gap-nz between the nozzles NZ in the head extension direction DR2. The interval gap-nz between the nozzles NZ may be varied, and among them, the smallest interval gap-nz between the nozzles NZ may be a value considered when determining the length of the elongated bottom portion of the partition wall 265 (referring to the spacer support portion CSL of FIG. 6) in the direction DR2 to form the spacer CS. This is described in detail in FIG. 6.

The head HEAD of the inkjet apparatus may reduce the interval gap-nz between the nozzles NZ in minimum by using a plurality of head HEADs while arranging them at substantially regular intervals. In this case, the minimum interval gap-nz between the nozzles NZ reduced by using a plurality of heads HEAD may be a value considered when determining the length of the elongated portion of the bottom surface of the partition wall 265 to be formed in the direction DR2 .

Here, the movement direction DR1 of the head HEAD extends generally orthogonal to extending direction DR2 of the head HEAD and the direction (i.e., direction DR2) determining the interval gap-nz between the nozzles NZ. As shown in FIG. 5, the extending direction of the head HEAD and the direction defining the interval gap-nz between the nozzles NZ may be the same direction DR2.

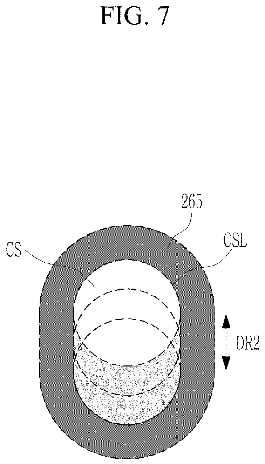

Hereinafter, the planar structure of the spacer support portion and the position of the spacer CS according to an embodiment are described in more detail with reference to FIG. 6 and FIG. 7.

FIG. 6 is a top plan view of an embodiment of a spacer and a partition wall disposed around a spacer constructed according to the principles of the invention, and FIG. 7 is a top plan view showing various positions of the spacer of FIG. 6.

FIG. 6 shows the spacer support portion CSL, which is at a bottom portion of the partition wall 265, and supports thereon the spacer CS. Here, the periphery of the spacer support portion CSL has a structure in which the partition wall 265 is further formed with a minimum width b. A portion where the periphery of the spacer support portion CSL with the minimum width b is also referred to as an additional margin portion hereinafter. FIG. 6 shows the periphery of the spacer support portion CSL has only the minimum width b, embodiments are not limited thereto. Thus, the partition wall 265 may be formed with a wider width than this, and various embodiments of the planar structures of the partition wall 265 are described in detail in FIG. 8, FIG. 16 and FIG. 17.

Referring to FIG. 7, the dotted lines show that the spacer CS may be formed at various positions according to the extending direction DR2 of the spacer support portion CSL. Here, the extending direction DR2 of the spacer support portion may be substantially the same direction as the extending direction DR2 of the head HEAD of the inkjet apparatus, and may correspond to the arrow direction shown by c in FIG. 6. FIG. 7 teaches that the position in which the spacer CS is formed may be different depending on the position of the nozzle NZ used among a plurality of nozzles NZ formed on the head HEAD of the inkjet apparatus.

Again, referring to FIG. 6, the spacer CS has a circular shape, and the diameter a may have a value of around 20 µm, while the value of the diameter a of the spacer CS may be 10 µm or more and 30 µm or less. According to an embodiment, the spacer CS may have a polygonal shape similar to a circle. Here, the spacer CS may be formed with a height of 2 µm or more and 10 µm or less.

The spacer support portion CSL is formed to have a size large enough to include the diameter a of the spacer CS, which becomes larger as the diameter a of the spacer CS increases.

Both ends of the extending direction of the spacer support portion CSL of the spacer support portion CSL may be formed in substantially the same planar shape as the planar shape of the spacer CS, in FIG. 5, according to the planar shape of the circular spacer CS, the planar shape of both ends of the spacer support portion CSL is formed in a generally semicircular structure.

In addition, the spacer support portion CSL is formed elongated in the direction in which the spacer CS may be formed by any one of nozzles of the moving head HEAD, that is, the extending direction of the spacer support portion CSL. The length of the extending direction of the spacer support portion CSL is formed so that there is a margin c even after forming the spacer CS. Here, the margin c may be determined based on the minimum value among the interval gap-nz between the nozzles NZ of FIG. 5. In the illustrated embodiment, the margin c is set to the value of the minimum interval gap-nz between the nozzles NZ. The minimum interval gap-nz between the nozzles NZ may vary depending on the inkjet apparatus, and the margin c may have a value of 14.1 µm or more and 70.5 µm or less. Here, considering the margin c and the diameter a of the spacer CS, the length of the extending direction of the spacer support portion CSL may be 24.1 µm or more and 90.5 µm or less.

However, when forming the spacer CS in the actual inkjet method, when considering precision and tolerances, in the partition wall 265 according to the illustrated embodiment, an additional margin portion having the minimum width b is formed around the spacer support portion CSL. As a result, the spacer CS may be formed to have a structure that always overlaps vertically with the partition wall 265. Here, the minimum width b may have a value around 10 µm, and the value of the minimum width b may be 5 µm or more and 15 µm or less.

According to the above structure, the partition wall 265 may be formed with the minimum width b at the spacer support portion CSL and the surroundings thereof, even if the spacer CS is formed with the inkjet method, it may be formed to be stably and reliably positioned on the partition wall 265.

Particularly, in the partition wall 265 of the illustrated embodiment, the spacer support portion CSL has a structure that extends elongated in one direction DR2 (the extending direction of the spacer support portion CSL), thereby having an anisotropic planar structure with the different widths based on the extending direction DR2 and the direction DR1 vertical thereto. As a result, in the head HEAD of the inkjet apparatus, the spacer CS is formed so that it could be positioned on the partition wall 265 even if the spacer CS is formed from any nozzle NZ among a plurality of nozzles NZ.

As a result, since a deposition mask process is obviated, manufacturing costs and process time are advantageously reduced.

On the other hand, the specific structure of the partition wall 265 has a structure having a width substantially equal to or greater than the minimum width b (e.g., margin width) in various directions of the spacer support portion CSL, and the specific structure of the partition wall 265 is described in detail based on FIG. 8.

FIG. 8 is a top plan view of an embodiment of a portion of the color conversion panel of FIG. 2.

FIG. 8 shows a partition wall 265, a spacer CS, a first color conversion layer 520a, a second color conversion layer 520b, and a transmission layer 520c. In addition, the partition wall 265 includes a first opening 267a, a second opening 267b, and a third opening 267c allowing the first color conversion layer 520a, the second color conversion layer 520b, and the transmission layer 520c to be positioned respectively, and a dummy opening 267-v may be further included. The dummy opening 267-v does not overlap the first color conversion layer 520a, the second color conversion layer 520b, and the transmission layer 520c, but overlaps the light blocking region. In addition, all openings adjacent to the periphery of the partition wall 265 on which the spacer CS is positioned may be the dummy openings 267-v, and the spacer CS may be positioned adjacent to the dummy openings 267-v of the partition wall 265.

On the other hand, in FIG. 8, pitches Pitch-x and Pitch-y between four spacers CSs adjacent to each other are shown.

The spacer CS may be positioned while changing the position according to the extending direction of the spacer support portion CSL, and in FIG. 8, the pitch Pitch-y in the vertical direction (e.g. direction DR2) may have a different value from the pitch Pitch-x in the horizontal direction. In FIG. 8, the pitch Pitch-y2 in the second vertical direction is additionally shown as the pitch Pitch-y in the vertical direction to show that the adjacent pitches in the vertical direction may be different from each other. FIG. 8 shows an embodiment in which the spacer CS positioned at the top is positioned upwardly among the spacer support portion CSL, the spacer CS positioned in the middle is positioned downwardly among the spacer support portion CSL, and the spacer CS positioned at the bottom is positioned at the middle among the spacer support portion CSL. However, the position of the spacer CS may be formed in various positions among the spacer support portion CSL.

More specifically, the pitch between spacer CSs may be described as follows. The pitch Pitch-x in the horizontal direction may all have a constant value and may have substantially the same value as an integer multiple of the pitch value of the pixel in the horizontal direction. On the other hand, the pitch Pitch-y in the vertical direction may have various values as the position of the spacer CS changes according to the extending direction, and may have different values between the adjacent pitches Pitch-y in the vertical direction. Also, the pitch Pitch-y in the vertical direction may have a different value from an integer multiple of the pitch value of the pixels in the vertical direction. Here, the pitch of the pixels may be determined based on the interval between the adjacent color filters, color conversion layers, and/or transmission layers, and the pitch may be determined based on the interval between the openings overlapping the emission layer in the partition wall.

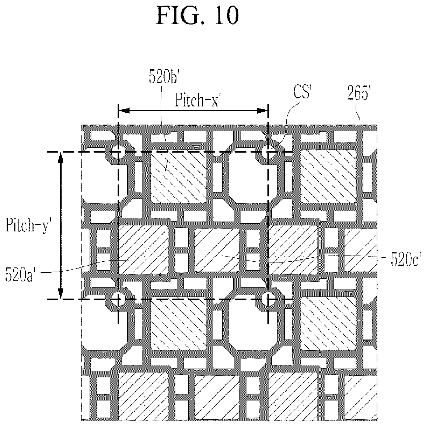

However, compared with a comparative example of FIG. 10, in the comparative example, a pitch Pitch-y' in a vertical direction and a pitch Pitch-x' in a horizontal direction for a spacer CS' have substantially the same value, so there is a difference compared with the embodiments shown in FIGS. 6-8.

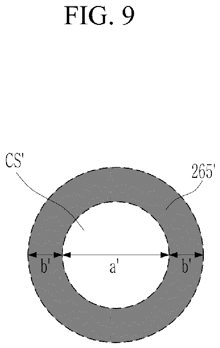

Hereinafter, the structure of the spacer CS' formed using a deposition mask is described through FIG. 9 and FIG. 10 for purposes of comparison with the illustrated embodiment.

FIG. 9 is a top plan view of a comparative example of a patterned spacer and a partition wall disposed around a spacer, and FIG. 10 is a top plan view of a comparative example of a color conversion panel.

The patterned spacer CS' according to the comparative example of FIG. 9 may be formed at the correct position because it is formed using a mask. Therefore, the spacer support portion coincides with the planar shape of the spacer CS', and the spacer support portion is not formed to be elongated in one direction.

The diameter a' of the spacer CS' in the comparative example may be equal to the diameter a of the spacer CS of FIG. 6, and the minimum width b' of the comparative example may be substantially the same as the minimum width b of the embodiment of FIG. 6.

Also, referring to FIG. 10, in the comparative example, the pitches Pitch-x' and Pitch-y' between four spacers CS' may be substantially the same as each other. That is, in the comparative example of FIG. 10, the pitch Pitch-y' in the vertical direction of the spacer CS' and the pitch Pitch-x' in the horizontal direction have substantially the same value.

In this comparative example of FIG. 9 and FIG. 10, it is possible to form the spacer at the correct position using the mask, but if the spacer is formed in the inkjet method, the spacer may be positioned on a part that does not vertically overlap the partition wall 265. In that case, a problem arises that the spacer cannot function properly.

However, as shown in FIG. 6 to FIG. 8, the spacer support portion CSL of the partition wall 265 has an anisotropic planar structure extending elongated in one direction DR2 (the extending direction of the spacer support portion CSL), so that the spacer CS may be formed on the partition wall 265 even if the spacer CS is formed from any nozzles NZ of a plurality of nozzles NZ in the head HEAD of the inkjet apparatus. Since a deposition mask process is not used to form the spaces CS, the manufacturing cost is reduced and the process time is also reduced.

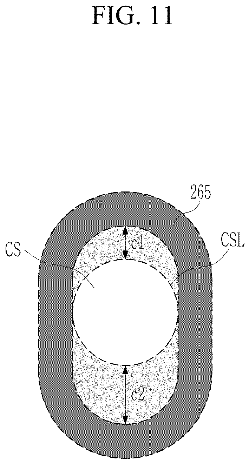

Hereinafter, numerous variation embodiments are described with reference to FIG. 11 to FIG. 19.

First, the modified embodiment of FIG. 6 is described with reference to FIG. 11 to FIG. 15.

FIG. 11 to FIG. 15 are top plan views of various embodiments of a spacer and a partition wall disposed around a spacer constructed according to the principles of the invention.

The embodiment of FIG. 11 is formed by moving the position of the spacer CS downward in the structure of FIG. 6.

In the embodiment of FIG. 11, the spacer support portion CSL and the spacer CS have a structure having a first margin c1 and a second margin c2, and the sum of the first margin c1 and the second margin c2 may be equal to the margin c of FIG. 6. The sum of the first margin c1 and the second margin c2 may have a value of 14.1 µm or more and 70.5 µm or less.

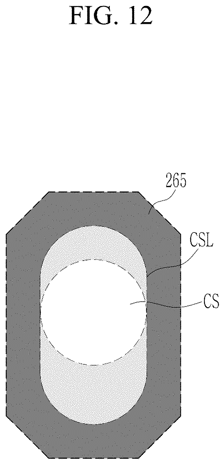

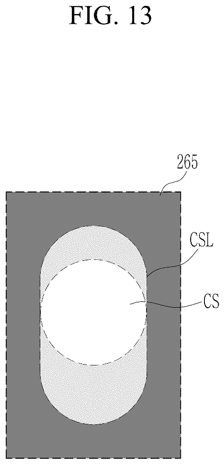

An embodiment of FIG. 12 and an embodiment of FIG. 13 are embodiments in which the planar shape of the additional margin portion formed with the minimum width positioned on the outside of the spacer support portion CSL in the embodiment of FIG. 11 is different from the planar shape of the spacer support portion CSL.

That is, as shown in FIG. 12, the planar shape of the additional margin portion has an octagonal shape extending long in one direction, or may have a rectangular shape extending long in one direction as shown in FIG. 13. According to the embodiment, the shape of the additional margin portion may be formed to be elongated in one direction and may have various shapes.

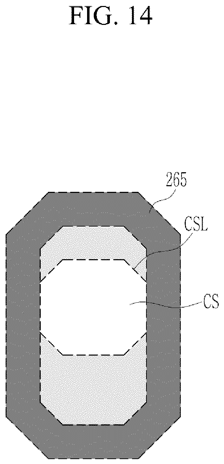

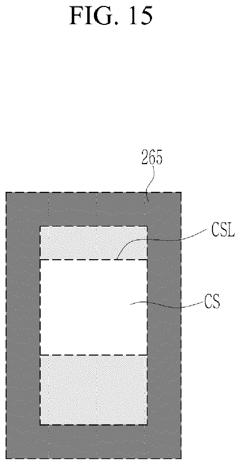

In the modified embodiment of FIG. 14 and FIG. 15, an embodiment in which the spacer CS is not circular is shown. In FIG. 14, the spacer CS has an octagonal shape, and in FIG. 15, the spacer CS has a quadrilateral shape. Depending on the shape of the spacer CS, the spacer support portion CSL also has an octagonal and a quadrangular shape, respectively, and the spacer support portion CSL is extended long in one direction.

In the embodiment of FIG. 14 and FIG. 15, the planar shape of the additional margin portion is substantially the same as the planar shape of the spacer support portion CSL, and the additional margin portion may have a structure having the minimum width on the outside of the spacer support portion CSL.

As described above, the spacer CS is positioned inside the spacer support portion CSL formed elongated in one direction, and the position of the spacer CS may be changed according to the extending direction of the spacer support portion CSL.

As described above, the spacer support portion CSL of the partition wall 265 has an anisotropic planar structure that extends elongated in one direction (the extending direction of the spacer support portion CSL), , and even if the spacer CS is formed from any nozzles NZ among a plurality of nozzles NZ in the head HEAD of the inkjet apparatus, the spacer CS may be formed on the partition wall 265. As a result, since no deposition mask process is used, the manufacturing cost is reduced and the process time is also reduced.

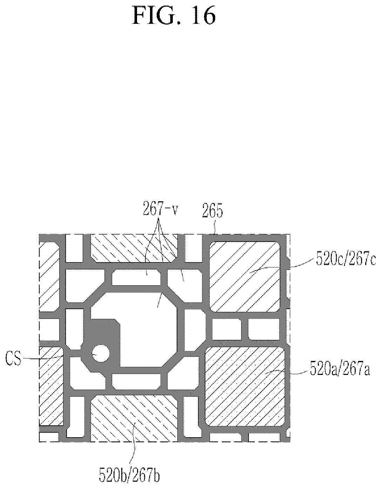

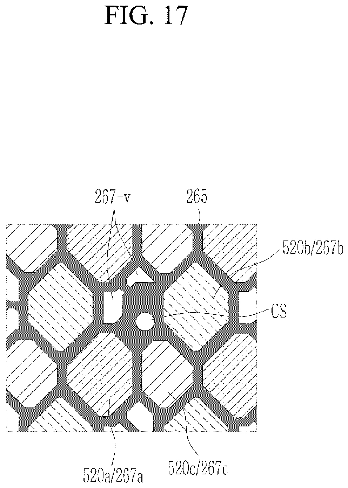

Hereinafter, the structure of the partition wall 265 from FIG. 8 is described with reference to FIG. 16 and FIG. 17.

FIG. 16 and FIG. 17 are top plan views of other embodiments of a portion of the color conversion panel of FIG. 2.

In the embodiment of FIG. 16, similar to the embodiment of FIG. 8, a first opening 267a, a second opening 267b, and a third opening 267c formed in the partition wall 265 and corresponding to a first color conversion layer 520a, a second color conversion layer 520b, and a transmission layer 520c have a quadrangle shape. However, the positions of the first opening 267a, the second opening 267b, and the third opening 267c are different from that of FIG. 8. The embodiment of FIG. 16 is an embodiment in which the openings adjacent to the periphery of the partition wall 265 on which the spacer CS is positioned are all dummy openings 267-v.

Referring to FIG. 16, the spacer CS is positioned on the part that is elongated in one direction among the partition wall 265, and the position of the spacer CS may be moved and positioned in one direction unlike the part shown in FIG. 16.

On the other hand, in FIG. 17, unlike FIG. 8, the first opening 267a, the second opening 267b, and the third opening 267c formed in the partition wall 265 have a modified hexagonal structure based on a rhombus shape. Referring to FIG. 17, the spacer CS is positioned on the part that is elongated in one direction among the partition walls 265, and the position of the spacer CS may be moved and positioned in one direction unlike the part shown in FIG. 17.

In the embodiment of FIG. 17, unlike FIG. 8, the openings adjacent to the periphery of the partition wall 265 where the spacer CS is positioned are not all dummy openings 267-v, and some of the openings may be one of the first opening 267a, the second opening 267b, and the third opening 267c, and one of the first color conversion layer 520a, the second color conversion layer 520b, and the transmission layer 520c may be positioned in the adjacent opening.

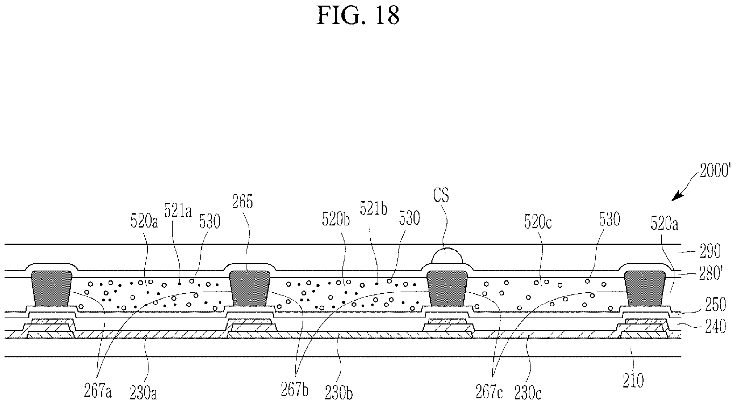

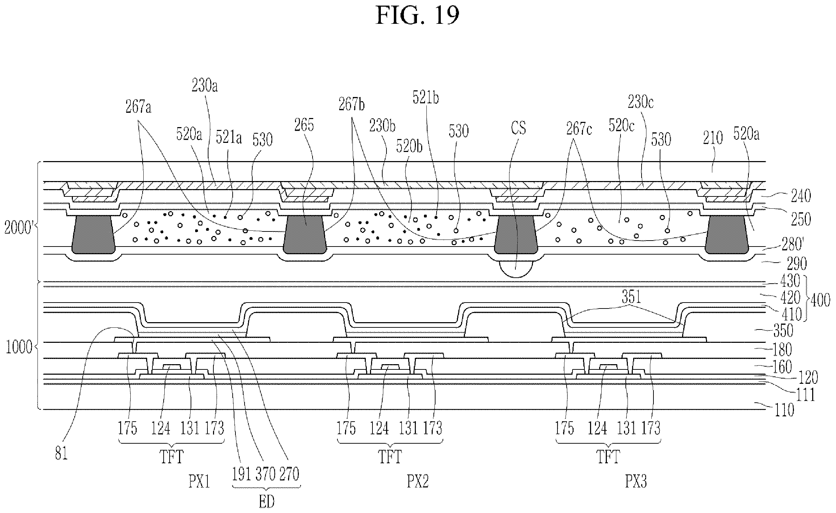

Hereinafter, the modified embodiment of FIG. 2 and FIG. 3 is described with reference to FIG. 18 and FIG. 19.

FIG. 18 is a cross-sectional view of another embodiment of a color conversion panel, and FIG. 19 is a cross-sectional of an embodiment of a light emitting diode display including the color conversion panel of FIG. 18.

In the embodiment of FIG. 18 and FIG. 19, unlike FIG. 2 and FIG. 3, the second capping layer 280' is positioned under the spacer CS and is positioned between the partition wall 265 and the spacer CS. That is, the second capping layer 280' is positioned on the first color conversion layer 520a, the second color conversion layer 520b, the transmission layer 520c, and the partition wall 265. The second capping layer 280' may be positioned entirely on the substrate 210. The second capping layer 280' is a layer that covers and protects the first color conversion layer 520a, the second color conversion layer 520b, and the transmission layer 520c, and may be made of an inorganic material. For example, the second capping layer 280' may include an inorganic insulating material such as a silicon nitride (SiNx), a silicon oxide (SiOx), or a silicon oxynitride (SiOxNy). The second capping layer 280' may be a single-layer or multi-layered structure of the material.

The spacer CS may be positioned on the second capping layer 280', and a filling layer 290 may be positioned on the spacer CS and the second capping layer 280'.

FIG. 19 shows a state in which the color conversion panel 2000' according to the embodiment of FIG. 18 is bonded to the display panel 1000.

In the embodiment of FIG. 18 and FIG. 19, the spacer CS is formed by the inkjet method, and the spacer support portion CSL of the partition wall 265 may have an anisotropic planar structure extending elongated in one direction (the extending direction of the spacer support portion CSL).

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

### [Industrial Applicability]

The present disclosure relates to a display device

## Claims

1. A light emitting diode display comprising:
a first panel including an emission layer and a pixel definition layer having an opening for a light emitting diode; and
a second panel positioned on the first panel and including a bank and a plurality of spacing elements,
wherein the bank overlaps the plurality of spacing elements and includes a plurality of spacer support portions extending longitudinally in a first direction a greater distance than it extends in a second direction intersecting the first direction, and
the plurality of spacing elements are disposed on the plurality of spacer support portions.

2. The light emitting diode display of claim 1, wherein
a pitch of the plurality of spacing elements in the second direction is equal to an integer multiple of a pitch of a plurality of pixels in the second direction, and a pitch of the plurality of spacing elements in the first direction does not correspond to an integer multiple of a pitch of the plurality of pixels in the first direction.

3. The light emitting diode display of claim 1, wherein
the spacing elements are formed by a movable head of an inkjet apparatus, and
the first direction is the same direction as an extending direction of the movable head and is orthogonal to a direction in which the head of the inkjet apparatus moves.

4. The light emitting diode display of claim 3, wherein the spacing elements comprises spacers having a diameter of 10 µm or more and 30 µm or less, and a height of 2 µm or more and 10 µm or less.

5. The light emitting diode display of claim 4, wherein
the bank comprises a partition wall and the spacer support portion comprises a bottom portion of the partition wall, and a margin of the first direction of the spacer support portion excluding the spacer is 14.1 µm or more and 70.5 µm or less.

6. The light emitting diode display of claim 5, wherein
the head of the inkjet apparatus comprises a plurality of nozzles, and
the margin of the first direction is the same as a minimum interval of the plurality of nozzles in the first direction.

7. The light emitting diode display of claim 5, wherein
a length of the first direction of the bottom portion is 24.1 µm or more and 90.5 µm or less.

8. The light emitting diode display of claim 5, wherein
the partition wall further comprises an additional margin portion positioned around the bottom portion, and
the additional margin portion has a width of 5 µm or more and 15 µm or less.

9. The light emitting diode display of claim 8, wherein
a planar shape of the additional margin portion is the same as or different than a planar shape of the bottom portion.

10. The light emitting diode display of claim 1, wherein
the second panel further comprises an upper capping layer,
the upper capping layer comprises one of a silicon nitride, a silicon oxide and a silicon oxynitride, and
the upper capping layer entirely covers the bank and the spacing elements.

11. The light emitting diode display of claim 1, wherein
the second panel further comprises an upper capping layer,
the upper capping layer comprises one of a silicon nitride, a silicon oxide, and a silicon oxynitride, and
the upper capping layer is positioned between the bank and the spacing elements.

12. The light emitting diode display of any one of claims 1 to 11, wherein
the bank comprises a partition wall having first opening, a second opening, and a third opening, and
the second panel further comprises a first color conversion layer positioned within the first opening, a second color conversion layer positioned within the second opening, and a transmission layer positioned within the third opening.

13. The light emitting diode display of claim 12, wherein
the opening for the light emitting diode is provided as multiple to comprise a plurality of openings for the light emitting diode, and
the plurality of openings for the light emitting diode overlap the first opening, the second opening, and the third opening of the partition wall, respectively.

14. The light emitting diode display of claim 13, wherein
the second panel further comprises a first color filter, a second color filter, and a third color filter,
the first color filter overlaps the first color conversion layer, the second color filter overlaps the second color conversion layer, and the third color filter overlaps the transmission layer, and
the second panel further comprises a light blocking region where at least two of the first color filter, the second color filter, and the third color filter overlap overlapping the partition wall.

15. The light emitting diode display of claim 14, wherein
the partition wall further comprises a dummy opening, and
the dummy opening overlaps the light blocking region.

16. A color conversion panel comprising:
a plurality of spacing elements;
a bank overlapping the plurality of spacing elements, and including a plurality of spacer support portions extending longitudinally in a first direction, the bank further including a first opening, a second opening, and a third opening;
a first color conversion layer positioned within the first opening;
a second color conversion layer positioned within the second opening; and
a transmission layer positioned within the third opening,
wherein the plurality of spacing elements overlap a portion of the plurality of spacer support portions, respectively.

17. The color conversion panel of claim 16, wherein
the plurality of spacing elements comprise a plurality of spacers having a pitch in the first direction different from a pitch in a second direction perpendicular to the first direction.

18. The color conversion panel of claim 16, wherein
the plurality of spacing elements comprise a plurality of spacers formed by a movable head of an inkjet apparatus, and
the first direction is the same direction as an extending direction of the movable head and is orthogonal to a direction in which the head of the inkjet apparatus moves.

19. The color conversion panel of claim 18, wherein
the bank comprises a partition wall and the plurality of spacer support portions comprise a plurality of bottom portions of the partition wall, and the partition wall further including a plurality of additional margin portions positioned around the plurality of bottom portions respectively,
each of the plurality of spacers has a diameter of 10 µm or more and 30 µm or less, and a height of 2 µm or more and 10 µm or less,
a margin of the first direction of the spacer support portion excluding the spacer positioned at each of a plurality of the bottom portions is 14.1 µm or more and 70.5 µm or less, and
each of the plurality of additional margin portions has a width of 5 µm or more and 15 µm or less.

20. The color conversion panel of claim 16, further comprising
a first color filter, a second color filter, and a third color filter,
the first color filter overlaps the first color conversion layer, the second color filter overlaps the second color conversion layer, and the third color filter overlaps the transmission layer,
a light blocking region where at least two color filters among the first color filter, the second color filter, and the third color filter overlap overlaps the bank, and
the bank further comprises a dummy opening, and the dummy opening overlaps the light blocking region.
